(19) Europäisches Patentamt
European Patent Office
Office européen des brevets

(11) **EP 3 594 731 A1**

(12) **EUROPEAN PATENT APPLICATION**

(43) Date of publication:
**15.01.2020 Bulletin 2020/03**

(51) Int Cl.:
**G02B 13/00** *(2006.01)*    **H01L 27/146** *(2006.01)*
**B29D 11/00** *(2006.01)*

(21) Application number: **18182654.6**

(22) Date of filing: **10.07.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **CSEM**
**Centre Suisse d'Electronique et de Microtechnique SA**
**2002 Neuchâtel (CH)**

(72) Inventors:
• **Gimkiewicz, Christiane**
 **85737 Ismaning bei München (DE)**
• **Nussbaum, Pascal**
 **2052 Fontainemelon (CH)**
• **Hendricks, Nicholas**
 **8810 Horgen (CH)**

(74) Representative: **P&TS SA (AG, Ltd.)**
**Avenue J.-J. Rousseau 4**
**P.O. Box 2848**
**2001 Neuchâtel (CH)**

(54) **MICRO-OPTICAL COMPONENT FOR GENERATING AN IMAGE**

(57) The present invention concerns a micro-optical component (100) for generating an image, comprising:
- a substrate (20), comprising a first surface (21) and a second surface (22), wherein the first surface (21) comprises an aperture (12), and the second surface (22) is arranged to be connected to pixel array (300),
- a lens (10; 10'), placed on the first surface (21) so as to cover the aperture (12), the focal point of the lens (10; 10') belonging to the second surface (22).

The lens (10; 10') comprises an obscuration element generating at the lens an obscured area (40) and an un-obscured area (50), wherein the obscuration element is dimensioned to reduce the light transmittance towards the pixels for a fraction of the viewing angles only and at the same time, the obscured area is dimensioned so that the optical resolution of the lines is not smaller than the image resolution given by the size of the pixels.

Fig.2A

**Description**

Field of the invention

The present invention concerns a micro-optical component for generating an image. The present invention concerns also an imaging device comprising this micro-optical component, a method for manufacturing the micro-optical component and a method for manufacturing the imaging device.

Description of related art

Nowadays, imaging devices, as for example and in a non-limiting way micro cameras, endoscopic cameras, light-weight vision systems for flying robots, and similar devices comprise image sensors connected, preferably directly connected, to ultra-thin or very flat optical components, so as to obtain an optic height in the order of few millimeters.

In this context, the optic height is the height (or the thickness) of optical component from the surface of the optical component cooperating with the image sensor to the interface of the optical component with the external surface.

In this context, a micro-optical component (or ultra-thin optical component or very flat optical component) is an optical component having an optic height in the order of few millimeters, e.g. 2 mm, 1 mm or smaller.

Such micro-optical components can be manufactured in precise and cost efficient wafer-scale processes like resist reflow for mastering and uv-replication for reproduction, which makes these technologies ideal candidates in order to obtain optic heights in the order of few millimeters. Other possible mastering methods are direct laser writing, grey-scale lithography, ultra-precision diamond turning/micro-machining. The considered lens, which is in general a single spherical lens, is replicated on a substrate, e.g. a glass chip, with an appropriate aperture and thereafter attached, in particular directly attached, to an image sensor.

In this context, a spherical lens is a lens having a spherical profile. In other words, a spherical lens is a convex lens whose cut section comprises an arc of circle.

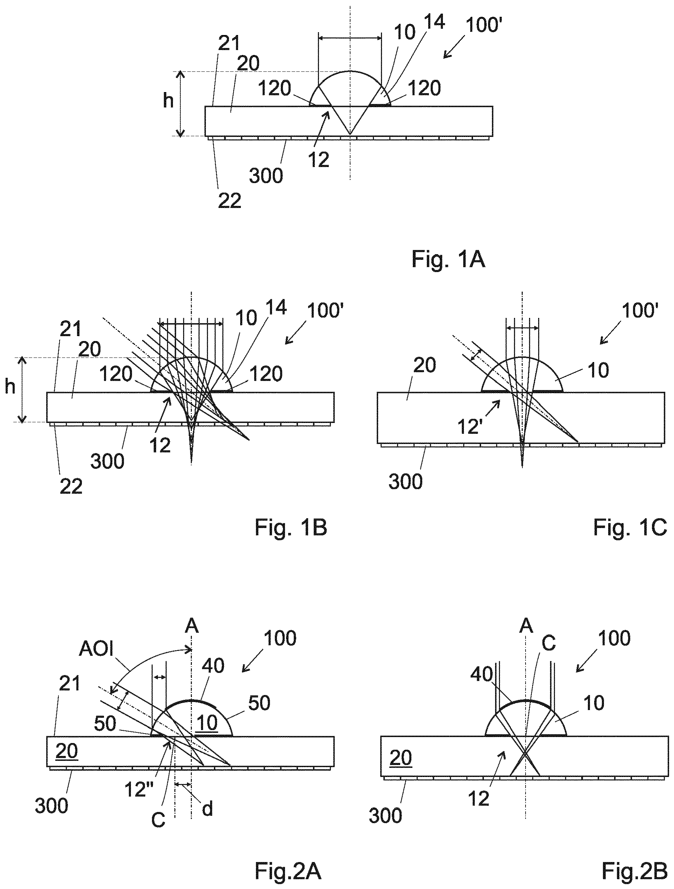

An example of a known micro-optical component 100' is visible on Fig. 1A: it comprises a single spherical lens 10 and a substrate 20. The lens 10 is placed on a first surface 21 of the substrate 20 so as to cover the aperture 12. The second surface 22 of the substrate 20, opposite to the first surface 21, is attached, for example directly attached, to an array 300 of light-detecting elements, e.g. pixels. The focal point of the lens 10 belongs to the second surface 22 of the substrate 20. The pixel array 300 allows to detect the image formed on the second surface 22.

The aperture 12 is for example a circular aperture defined by a substrate obscured area or layer 120 created on the first substrate 21 before the lens 10 is placed on the first surface 21. The lens 10 is created on the first substrate 21 so as to cover, in particular completely cover, the aperture 12, e.g. by using the uv-embossing fabrication process. This substrate obscured area 120 can for example be obtained by coating at least a part of the first surface 21 with a material preventing the light to pass through it, this coating being performed before creating the lens 20 on the first surface 21 of the substrate 20.

The lens 10 of Fig. 1A is spherical, as it is a convex lens whose cut section comprises a single arc of circle 14. In the illustrated example, the lens 10 has a circular basis, a part of this circular basis completely covering the aperture 12.

The lens 10 of Fig. 1A receives incident light of a determined range of wavelengths, for example the range of the visible spectrum (400 nm - 700 nm) and/or the range of the near infrared spectrum (700 nm - 900 nm).

The micro-optical component 100' has an optic height h typically equal or less than 1 mm. The thickness of the substrate is a function of the focal length of the lens, e.g. its radius. The more flat the lens, the longer the focal length, and the thicker the substrate.

The known micro-optical component of Fig. 1A has some advantages: it has a robust design, it can be manufactured by wafer-scale fabrication methods as for example uv-embossing and it comprises a low number of optical surfaces.

However, the known micro-optical component of Fig. 1A presents two main drawbacks, in particular for large field of views (with maximum viewing angles equal or higher than 100°, e.g.120°): intensity fall-off at the image edge and spherical aberrations.

In this context, the expression "field of view" is a measure (e.g. in degrees) of the angular range of a scene or a subject the lens can take in.

In this context, the expression "angle of incidence" (AOI) indicates the angle between a ray incident on the lens and the normal of the substrate at the point of incidence.

First, large field of views suffer most from the intensity fall-off at the image edge.

Secondly, for wide viewing angles a single spherical lens suffers from spherical aberrations, visible in Fig. 1B. In other words, the focal points of the diverse AOI are on a curved plane: thus the larger the AOI, the shorter becomes the effective identical back focal length or BFL (i.e. the distance from the back of the lens to the focal point of the lens when focusing light from infinity). The caused image blur is usually reduced by a smaller aperture 12' (visible in Fig. 1C) at the cost of light, in order to best focus large AOIs.

Therefore, there is a need for a micro-optical component in which the problems of intensity fall-off at the image edge and/or the image blur due to spherical aberrations for wide field of view can be mitigated or reduced with regard to the known solution.

There is also a need for a micro-optical component which equalizes the intensities for central and marginal AOIs while reducing the aberration by suppressing aberrated and blinding rays.

There is also a need for a micro-optical component adapted to an image sensor having intelligent pixels with a low fill factor.

Brief summary of the invention

According to the invention, these aims are achieved by means of the optical component according to claim 1. These aims are also achieved by means of the imaging device according to claim 13, by means of the method for manufacturing the micro-optical component according to claim 15 and by means of the method for manufacturing the imaging device according to claim 17.

The micro-optical component for generating an image on an array of light detective elements, e.g. pixels, according to the invention comprises:

- a substrate comprising a first surface and a second surface, wherein the first surface comprises an aperture and the second surface is arranged to be placed on the array,
- a lens placed on the first surface so as to cover the aperture, the focal point of the lens belonging to the second surface.

Advantageously, the micro-optical component comprises also an obscuration element, the area of the obscuration element being less than the area of the lens, so that at least a first part of a light beam incident to the lens pass through the lens, thereby generating the image on an array of light detective elements, the obscuration element preventing at least a second part of the light beam to pass through the lens, so as to improve the intensity homogeneity of the image and/or to reduce image blur due to spherical aberrations.

The invention will be better understood with the aid of the description of an embodiment given by way of example and illustrated by the figures, in which:

Fig. 1A shows a cut-section view of a known micro-optical component.

Fig. 1B shows a cut-section view of the known micro-optical component of Fig. 1A, with two light beam with different angles.

Fig. 1C shows a cut-section view of another known optical component.

Fig. 2A shows a cut-section view of one embodiment of a micro-optical component according to the invention.

Fig. 2B shows a cut-section view of another embodiment of a micro-optical component according to the invention.

Fig. 3 illustrates a graphic of different Modulation Transfer Functions (MTFs) of a lens with regard to the spatial frequency, normalised to the optical cut-off frequency, for different obscuration levels $\varepsilon$.

Fig. 4 illustrates graphic of different Strehl ratios with regard to the z coordinate, for an aberration-free point image (continuous line) and for an aberrated point image (dotted line).

Fig. 5 shows a perspective view of one embodiment of the micro-optical component according to the invention.

Fig. 6 shows a cut-section view of another embodiment of a micro-optical component according to the invention.

Fig. 7 shows a cut-section view of an embodiment of a lens for a micro-optical component according to the invention.

Fig. 8 shows a perspective view of an embodiment of a micro-optical component according to the invention.

Fig. 9 shows a cut-section view of another embodiment of a lens for a micro-optical component according to the invention.

Fig. 10 shows a cut-section view of an embodiment of a micro-optical component according to the invention, comprising the lens of Fig. 9.

Figs. 11A to 11C show three perspective views, each view representing one embodiment of a micro-optical component according to the invention in a particular step of its fabrication.

Figs. 12A to 12E show five cut-section views, each view representing one embodiment of a micro-optical component according to the invention in a particular step of its fabrication.

Fig. 13 shows a cut-section view of another embodiment of a micro-optical component according to the invention.

Fig. 14 shows a top view of a pixel.

Fig. 15A shows a cut-section view of another embodiment of a micro-optical component according to the invention.
Fig. 15B shows a cut-section view of an array pixel.

Figs. 16 illustrates a cut-section view of another embodiment of a micro-optical component according to the invention.

Fig. 17 shows a perspective view of one embodiment of the micro-optical component according to the invention.

Detailed description of possible embodiments of the invention

Fig. 2A shows a cut-section view of one embodiment of a micro-optical component 100 according to the invention. As the known micro-optical component 100' of Figs. 1A to 1C, it comprises:

-    a substrate 20, comprising a first surface 21 and a second surface 22, wherein the first surface comprises an aperture 12", and the second surface is arranged to be connected to an image sensor comprising a pixel array 300, e.g. via a glue or adhesive layer (not illustrated),
-    a lens 10, placed on the first surface 21 so as to cover aperture 12", the focal point of the lens 10 belonging to the second surface 21.

The presence of a substrate 20 allows to avoid internal reflection in the lens 10, in particular for large AOIs.
In one preferred embodiment, the refractive index of the substrate 20 is substantially equal to the refractive index of the lens 10.
According to the invention, the micro-optical component 100 of Fig. 2A comprises an obscuration element. In the embodiment of Fig. 2A, the obscuration element is on the lens. It defines at the lens an obscured area 40 and an unobscured area 50, wherein a part of the light beam is prevented to pass through the obscured area 40 and another part of the light beam is allowed to pass through the unobscured area 50.
According to the invention, the area of the obscuration element is less than the area of the lens 10, so that at least a first part of a light beam incident to the lens pass through the lens, thereby generating the image on an array of light detective elements 300, this obscuration element preventing at least a second part of said light beam to pass through the lens, so as to improve the intensity homogeneity of the image and/or reduce image blur due to spherical aberrations.
In one preferred embodiment, an example of which is illustrated in Fig. 2A, the obscuration element generating the obscured area 40 is on the external surface of the lens 10. It is for example a coated layer on the external surface of the lens 10. The remaining non-coated external surface of the lens is the unobscured area 50. Other means for performing the obscuration different from the coating can be used, e.g. and in a non-limiting way evaporation, lithography and/or use of an obscuring packaging, i.e. a packaging comprising parts obscuring the optical component.
In another (not illustrated) embodiment, the obscuration element is on the internal surface of the lens 10. However it must be understood that the obscuration element is not necessarily on a surface of the lens, but can be in alterative or in complement in the lens: e.g. if the lens replication is done not in a single layer but in multiple layers, the obscuration can be processed on any surface level inside the lens or even in front of the lens.
In another (not illustrated) embodiment, the obscuration element in front of the lens or behind the lens.
In the embodiment of Fig. 2A, the obscured area 40 is symmetric with regard to the axis of symmetry A.
The light blocking function of the obscuration is angle dependent. In other words, the obscuration element improves the image resolution for a first range of the angles of incidence while lowers the image resolution for a second range of the angles of incidence.
First considering a lens without obscuration as shown in Fig. 1A: depending on the AOI, the effective transmitting area of the aperture of radius $r_0$ becomes an ellipse with the axial radii equal to $r_0$ and $r = r_0 * \cos(AOI)$. For the lens of Fig. 2A, the obscuration with radius $r_0$ placed at a distance $z_{obs}$ above the aperture forms an elliptic shadow on the transmittive aperture area. The shadow ellipse has the dimensions $r_{obs,0}$ and $r_{obs} = r_{obs,0} * \cos (\text{AOI})$. The position of the obscuration shadow $\Delta$ versus the center of the aperture determines the light blocking function of the obscuration:

| | |
|---|---|
| If $\Delta \leq |r - r_{obs}|$ | then there is the maximum blocking effect |
| If $|r - r_{obs}| < \Delta \leq r + r_{obs}$ | the blocking effect is increasing |
| If $\Delta > |r + r_{obs}|$ | there is no blocking effect |

Typical values are $(r_{obs,0})^2 = \varepsilon * r_0^2$, $\varepsilon = 20\% - 50\%$, $z_{obs} = 0.3$ mm, $r_0 = 0.15$ mm, so that the blocking effect is decreasing within the range $11° - 27° < \text{AOI} < 41° - 50°$. In other words, the obscuration element affects the intensity of almost all viewing angles except those larger than 41°-50°.

Therefore, the transmitted power of viewing angles close to the optical axis is reduced most. Thus, the benefit of such an obscuration is to decrease the intensity difference of central and marginal parts of the image.

The realization of an obscured area for a lens is surprising, because an obscuration at the entrance pupil has a negative effect on the resolution of the lens 10.

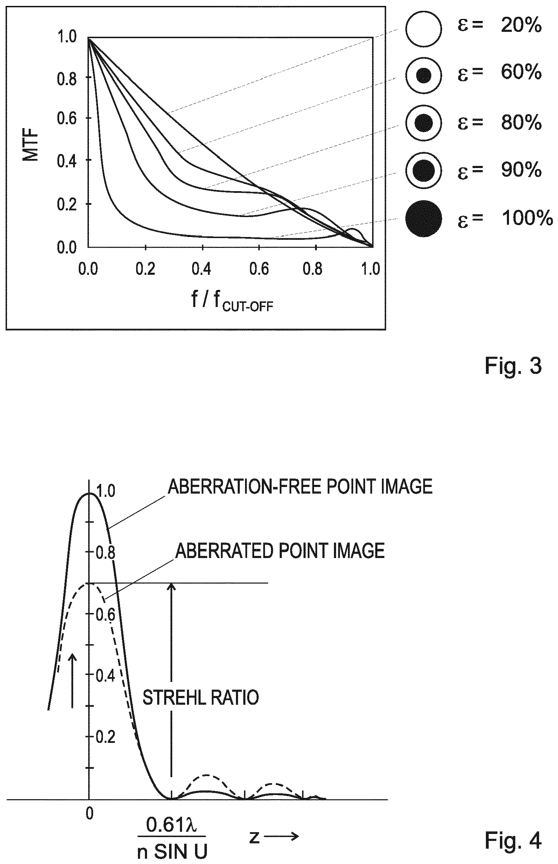

Fig. 3 illustrates a graphic of different Modulation Transfer Functions (MTFs) of a lens with regard to the spatial frequency, normalised to the optical cut-off frequency, for different obscuration levels $\varepsilon$.

In this context, the obscuration level $\varepsilon$ is defined as the ratio between the obscured area of the entrance pupil EP of the lens and the total area of the entrance pupil EP of the lens.

As visible in Fig. 3, for small AOIs, the higher the obscuration level $\varepsilon$, the lower the MTF. In other words, the more the obscured area at the entrance pupil, the lower the quality of the image, since the noise due to the diffraction in the image is increased.

The point spread function of a lens is known as "Airy pattern" and the relation of the central peak to the function side lobes is called "Strehl ratio". Fig. 4 illustrates graphic of different Strehl ratios with regard to the z coordinate, for an aberration-free point image (continuous line) and for an aberrated point image (dotted line). In Fig. 4, the point $0.61 * \lambda / n \sin(U)$ denotes the size of the central Airy disk, it is the radius where the beam power becomes zero; U is the beam divergence angle, n is the refractive index, $\lambda$ the wavelength.

As visible in Fig. 4, the Strehl ratio, which quantifies the quality of the image, is lower for an image aberrated by an obscuration.

By resuming, by increasing the obscured area, the Strehl ratio and thereby the optical quality of the image are decreased.

In one preferred embodiment, the area of the obscuration element allows to have a micro-optical component adapted for wide fields of view, without decreasing the optical quality of the image due to the presence of the obscured area.

In one preferred embodiment, the invention is therefore based on such a trade-off. The optical resolution of the lens is defined by the cut-off frequency of the point-spread function (cf Airy pattern and diffraction limit), defining a limit for the transmitted spatial frequency of a lens having a F-number F for a minimum MTF contrast of 50% at a given wavelength $\lambda$, according to the following formula:

$$f_{\text{cut-off\_o}} = 1 \text{ line } / (\lambda F) \qquad\qquad (1)$$

Typical values for the optical resolution of the lens $f_{\text{cut-off\_o}}$ can be in the order of several hundred lines per mm; especially low power systems with the necessity of small F# numbers (F# < 2) might have cut-off frequencies $f_{\text{cut-off\_o}} > 600$ lines/mm, and a MTF contrast of 50% is achieved for spatial frequencies in the order of 150 lines/mm. In practical systems, such a resolution is not required. Thus, the lens according to the invention is an applicable solution if the required resolution of the pixels is smaller than the optical resolution defined by equation (1), and the required MTF contrast.

In one embodiment, the applicant has discovered that the range from 20% to 50% for the obscuration level $\varepsilon$ allows to obtain satisfying results.

Since the obscuration element prevents at least a part of a light beam to pass through the lens, the intensity homogeneity of the image is improved and/or the image blur due to spherical aberrations reduced. On the other hand, the area of the obscuration element allows also that the optical resolution of the micro-optical component is equal or larger than the image resolution given by the light detective elements.

By properly selecting this area, it is possible to realize a micro-optical component in which the problems of intensity fall-off at the image edge and/or the image blur due to spherical aberrations for wide fields of view of the known micro-optical component using single spherical lens (with no obscuration) are reduced, without compromising the optical quality of the image due to the presence of the obscured area of the lens.

Moreover, especially for large sensor pixels, i.e. for pixels having a pitch equal or larger than 3 µm, e.g. 5 µm, the required resolution by the sensor's pixel size is much less than the resolution offered by the unobscured lens; in this case an obscuration in the entrance pupil diameter will not show a visible effect in the image.

This range has been selected by considering both the cut-off frequency by the point-spread function (equation (1)), and the cut-off frequency by pixel pitch, defining the maximum spatial frequency that can be transmitted by an image sensor with pixel pitch p, according to following formula:

$$f_{\text{cut-off\_p}} = 1 \text{ line } / (2p) \qquad (2)$$

Advantageously, the total optical track length (TOTR) of the micro-optical component according to the invention, i.e. the sum of the back focal length (required optical path length after the lens) and the rear focal length (required optical path length in the lens) is 1 mm or less.

In the embodiment illustrated in Fig. 2A, the lens 10 has a spherical profile. In this embodiment, the radius of the lens is less than 1 mm, e.g. 0.5 mm.

In the embodiment illustrated in Fig. 2A, the aperture 12", which is preferably circular, is shifted with regard to the lens 10. In other words, the lens 10 is placed on the first surface substrate 21 so that the axis of symmetry A of the lens 10 does not pass through the center C of the aperture 12", so that there is a shift or distance d from the center C to the axis of symmetry A.

This shifted aperture allows to increase the resolution at parts of the image at the cost of image resolution in other parts. The spherical lenses with shifted aperture are in general placed on the array 300 in such a way that only the best resolution parts of the image (or sub-images) are on the photosensitive pixels.

In one preferred embodiment, the final image is obtained by stitching together of those sub-images.

As the aperture underneath the spherical lens 10 is shifted out of the center C of the spherical lens 10, aberrations are reduced for the diametrical part of the image at the price of higher aberrations in the rest of the image. Moreover, the illumination for all the AOIs is equalized and/or double images are avoided with regard to the embodiment of Fig. 2B, in which the obscured lens 10 is centred on the aperture 12 (in other words, the axis of symmetry A of the lens 10 passes through the center C of the aperture 12 of Fig. 2B).

In one embodiment, the back focal length can also be optimized for the outer field of view.

In one preferred embodiment, if the lens 10 of the micro-optical component according to the invention is spherical and with a shifted aperture (as in the example of Fig. 2A), more than one lens 10 can be placed to the substrate 20, in order to have a full image.

The presence of the shifted aperture causes the capture of an image wherein only a portion of the image is usable, the size of the portion depending on the shifting of the aperture with respect to the axis of symmetry A of the lens 10.

Therefore, in one embodiment, the micro-optical component according to the invention comprises more than one spherical and obscured lens 10 with a shifted aperture, the at least two lenses 20 being identical. The apertures under each of the at least two lenses are identical as well.

In this case, the image sensor is arranged to communicate with a processor arranged to shift and/or accurately combine the images from each lens, so as to form a full image. In fact, the use of more than one lens requires image reconstruction.

In one preferred embodiment, image processing is minimized in order to economize energy.

In case of very large pixels, the image resolution of the very flat optics is already sufficient to resolve the active diode area of the image sensor only and the full resolution information is immediately available in the images.

In case of a low resolution optics, i.e. a resolution that is not lower than the pixel pitch, image deblurring techniques like deconvolution algorithms can be applied to achieve the desired resolution.

In one preferred embodiment, the number of those lenses 10 is even. In another preferred embodiment, those lenses are arranged in a M × M square, wherein M is the number of lenses per side.

As will be discussed, the use of multiple lenses allows to increase the resolution of the final image, for example by shifted sub-sampling or by spatial oversampling.

In one preferred embodiment, M = 2 so that there are four identical spherical and obscured lenses 10 on the substrate 20, each lens cooperating with a shifted aperture. In other words, the scene is collected by four separated lenses 10. The shift of their aperture 12 is selected so that each lens 10 gives an image wherein only a quadrant (i.e. ¼ of the image) is usable.

In one preferred embodiment, as will be discussed, the pitch between two consecutive lenses LP (i.e. the distance between the axes of symmetry of two consecutive lenses) is selected according to the following formula:

$$LP = (N + ½) \cdot p \qquad (3)$$

wherein N is the number of pixels per row of the pixel array 300 with N * N pixels and p is the pitch of each pixel.

For a number M of lens, the previous formula can be generalised as following:

$$LP = (N/M + 1/M) \cdot p \qquad\qquad (4)$$

In one preferred embodiment, the pitch is selected so that it can enable the image recomposition by simple pixel interleaving.

In one preferred embodiment, those lenses share the same substrate 20, so that the micro-optical component can be easily manufactured (as the lens can be easily replicated e.g. via uv-replication) and can be safely connected, e.g. via a glue or an adhesive layer, to the image sensor with an accurate pitch towards each lens.

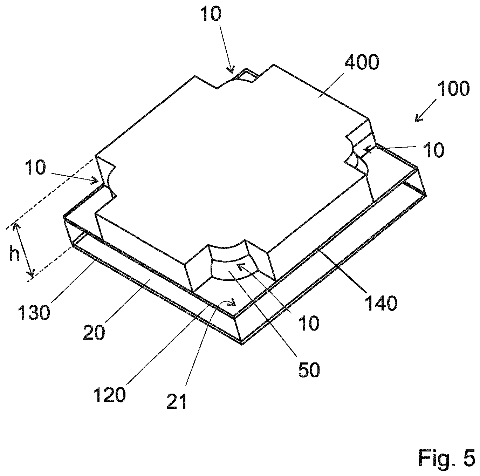

Fig. 5 illustrates a perspective view of one embodiment of the micro-optical component 100 according to the invention.

The micro-optical component 100 of Fig. 5 comprises 2 × 2 identical spherical and obscured lenses 10 on the substrate 20 e.g. a glass substrate 20. Each of the lens 10 cooperates with a shifted aperture (not visible) so that each lens is imaging only one quadrant of the total field of view. The image of each lens 10 is named in the following a quadrant image.

The substrate will be connected to an image sensor (not illustrated) via an adhesive or glue layer 130. Another adhesive or glue layer 140 allows to fix the lens 10 to the cover 400. In one embodiment, the image sensor has a size of about 4 mm × 4 mm.

The first surface 21 of the substrate 20 is coated with the layer 120, defining the apertures (not visible) under each lens 10.

In one preferred embodiment, the aperture layer 120 is manufactured by lithography on the substrate 20. The preferred material is the black chromium. In one preferred embodiment, the lithography reticule allows different aperture values. The varying of the aperture allows to compensate fabrication tolerances, e.g. the tolerance of the substrate's thickness. For example, if the substrate is too thick, a compensation can be achieved by choosing a smaller aperture, for example a smaller aperture diameter. On the contrary, if the substrate is too thin, it is possible to increase the thickness of the glue layer for compensating it.

In one preferred embodiment, the diameter of the aperture can be varied in a range from 0.20 mm to 0.40 mm.

In the embodiment of Fig. 5, the obscuration of the four lenses 10 is obtained by using a mask cover 400 which prevents the light to pass through it.

This mask cover 400 has a particular 3D shape allowing on one side to perform the obscuration of the lenses 10 and on the other side to protect the micro-optical component 100 as a sort of partial package.

The particularity of the embodiment of Fig. 5 is that the four lenses 10 are arranged so that the open apertures 50 of the lenses 10 are at the external edges of the micro-optical component 100, and not towards the center of the micro-optical component 100. This allows to minimize the distance between the four images of the four lenses: otherwise the large viewing angles and the size of the mask cover 400 would have required a larger loss of image sensor area.

Advantageously, the total height of the micro-optical component 100 of Fig. 5 is less than 1.5 mm, e.g. less than 1.3 mm.

The micro-optical component 100 of Fig. 5 allows to obtain the maximum image brightness for AOI ≠ 0° (instead of AOI = 0° as it is for conventional lenses). In one preferred embodiment, the maximum image brightness is obtained for AOI of about 30°.

The AOI = 0° point of the assembly of four lenses, e.g. the assembly illustrated in Fig. 5, is in the corners of the quadratic image sensor area that is used.

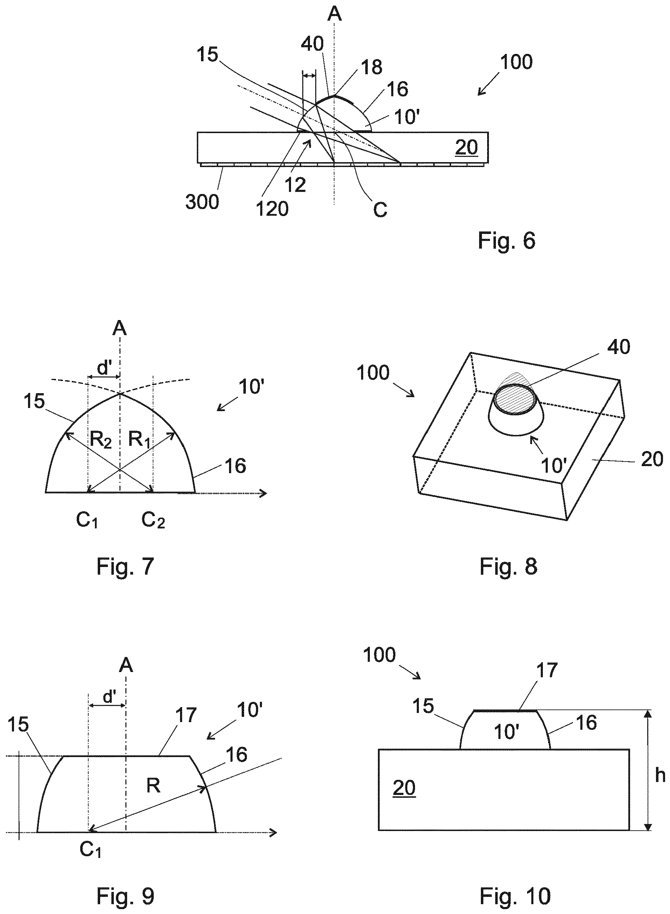

Fig. 6 shows a cut-section view of another embodiment of a micro-optical component 100 according to the invention. In this embodiment there is only a single lens 10' having an aspherical profile 16. In other words, the lens 10' is a convex lens whose cut section comprises two different arcs of circle 15, 16, belonging to two circles having different centres, i.e. the two arcs of circle 15, 16 crossing at a tip 18.

The aspherical lens 10' of Fig. 6 is symmetric with regard to the axis of symmetry A, which passes through the tip 18. Moreover, the aspherical lens 10' is centred on the aperture 12, as the axis of symmetry A, which passes through the center C of the aperture 12.

However, aspherical lenses 10' cooperating with shifted apertures could be imagined as well.

According to the invention, the aspherical lens 10' comprises an obscured area 40 at the entrance pupil of the lens 10', so that the ratio between the unobscured area of the entrance pupil and the total area of at the entrance pupil is comprised in the range from 20% to 50%.

In the embodiment of Fig. 6, the obscured area 40 is symmetric with regard to the axis of symmetry A. This is also visible in Fig. 8, which shows a perspective view of an embodiment of a micro-optical component according to the invention.

Fig. 7 shows a cut-section view of an embodiment of an aspherical lens 10'. The cut-section of this aspherical lens 10' is formed by the intersection of two ideal semi-circumferences (partially illustrated in Fig. 7 with dotted lines), one centered in C1 and having a radius R1 and the other centered in C2 and having a radius R2 = R1. In one embodiment, R1 and R2 are less than 1 mm, for example 0.5 mm. In one embodiment the distance d' from the center C1 (or C2) to the axis of symmetry A of the lens 10' is less than 0.20 mm, e.g. 0.15 mm.

One can imagine that the two ideal semi-circumferences are cut-sections of corresponding ideal spherical lenses, each of which cooperates with a shifted aperture. The distance between the centers C1 and C2 has been selected so that the aspherical lens 10' is centered on the aperture 12. In other word, the aspherical profile of the lens 10' is generated by cutting out the shift of the shifted aperture of the corresponding ideal spherical lenses of centers C1 and C2.

However, the aspherical profile of the aspherical lens 10' induces a decrease in the tangential resolution. Further optimization allows to balance this tangential resolution and also radial resolution. In one embodiment, such optimization is based on building up a merit function with the Strehl ratio, the modulation contrast and the intensity distribution as parameters. By variation of the lens geometry, e.g. by variation of some polynomial parameters (the lens geometry can be described best by a polynomial function), the obscuration diameter, the lens thickness, etc., a merit function is recomputed, thereby optimizing the lens profile.

As the covered top of an aspherical lens 10' has no optical purpose, in one preferred embodiment, illustrated in Figs. 9 and 10, it can be removed in order to further reduce the lens height (as long as there is no impact on the area that is not covered).

Therefore, in one embodiment, the aspherical lens 10' comprises a flattened and obscured top 17. In one preferred embodiment, this cut is realised at a height $h_L$ of about 0.30 mm from the substrate 20.

The embodiment with the flattened and obscured top 17 allows to have a micro-optical component 100 having a still more reduced optic height h, in particular a height of 1 mm or less (depending on the choice of the materials).

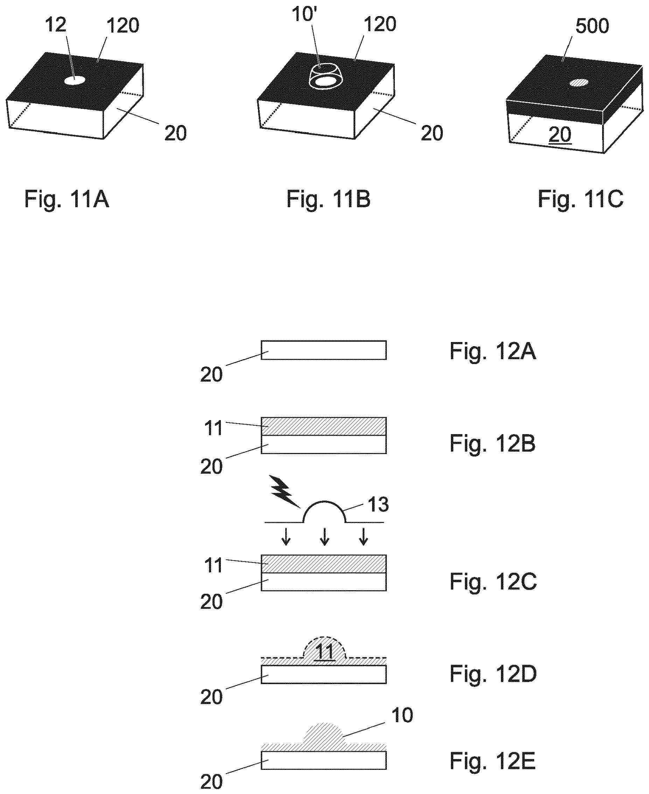

Figs. 11A to 11C show three perspective views, each view representing one embodiment of a micro-optical component according to the invention in a particular step of its fabrication.

In particular, in Fig. 11A a substrate 20, e.g. a glass substrate, with a layer 120 preventing the light to pass through, this layer being on all the first surface of the substrate 20 except for the aperture 12.

The illustrated aperture is circular, but other possible shapes could be imagined (e.g. in case of an astigmatic lens). The layer 120 can be fabricated with a process (e.g. the lithography) allowing the variation of the size of the aperture 12 (e.g. its diameter) for compensation as previously discussed.

Then, as illustrated in Fig. 11B, a lens (in this case an aspherical lens 10') is created on the substrate 20 so as to cover the aperture 12. For aspherical shapes, the lens master can be fabricated by micro-machining, laser writing or grey-scale lithography. This lens master will be used in the uv-embossing process, illustrated in Figs. 12A to 12E.

Then, as illustrated in Fig. 11C, the lens 10' is coated with a shadow mask 500 allowing the creation of the obscured area. As discussed, other methods could be used for creating the obscured area of the lens.

Figs. 12A to 12E show five cut-section views, each view representing one embodiment of a micro-optical component according to the invention in a particular step of its fabrication.

In particular, in Fig. 12A a substrate 20, e.g. a glass substrate (in particular a glass wafer), is provided. Then, as illustrated in Fig. 12B, a layer 11, e.g. a layer of a liquid polymer, is placed on the substrate 20. Then, as illustrated in Fig. 12C, a mould or die 13 is placed on the layer 11 so that via UV curing (Fig. 12D), a lens 10 (visible in Fig. 12E) is created. Those steps allow to perform a wafer-scale fabrication of the micro-optical component according to the invention by uv-embossing.

As anticipated, the number of lenses is a feature useful to increase the resolution of the final image, for example by shifted subpixel sampling. This is a technique know from super-resolution imaging: a camera with a low resolution grid of pixels takes images, but in-between the images the camera is shifted laterally by a distance that is smaller than the pixel pitch (subpixel). These low resolution images are superimposed to a high resolution image.

According to an important embodiment of the invention, instead of shifting a camera, $M \times M$ lenses of the type shown in Fig. 6 are used; each lens is shifted by a fraction of the pixel size towards each other in order to achieve images per lens on coarse pixel grids that can be merged to a high-resolution image.

Multiple images can be captured in parallel, in particular with ultra-flat lenses: for example if the image sensor has a total pixel number of $200 \times 200$ pixels, and if the subpixel sampling is performed with $2 \times 2$ lenses of Fig. 6, so that each lens has a resolution for example of $N/2 \times N/2 = 100 \times 100$ pixels, the resolution of the final image of the interlaced subpixel sampled images becomes:

$$(2 \times N/2) \times (2 \times N/2) = 200 \times 200 \text{ pixels.}$$

It is the identical resolution as if a single (larger) lens would have been used for imaging the image on the initial N x N pixels.

According to an important embodiment of the invention, the use of multiple but identical very flat optic lenses, each positioned accurately to allow sub-pixel sampling allows to compensate low fill factor pixels, i.e. the ratio between active photodiode area and pixel area.

In fact, especially for intelligent pixels, the pixel size is quite large and the pixels suffer from a low fill factor, since intelligence is incorporated into each pixel instead of being located at the circumference of the pixel field. The advantage of such sensors with sparse photo sensitive pixels is that the signal pre-processing in the pixel economises the time for data transfer to the sensor periphery; it goes in parallel with a decrease in the number of interconnects and a reduced noise sensitivity. Such an intelligent pixel may have a fill factor far below 70%, e.g. less than 50%. Here it is proposed to compensate the low fill factor by using the above-mentioned sub-pixel sampling.

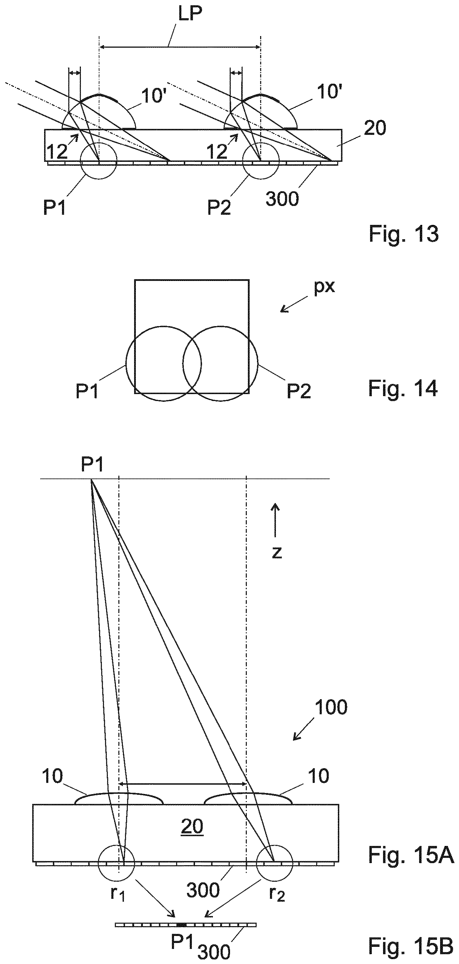

Fig. 13 shows a cut-section view of an embodiment of a micro-optical component 100 according to the invention, cooperating with a pixel of Fig. 14. In Fig. 13 is visible the lens pitch LP, which as discussed in one embodiment is at least (N/M + 1/M)p. The combination of Figs. 13 and 14 shows also that different parts P1, P2 (e.g. quarters) of large pixels are illuminated for the same AOI.

In Fig. 14, a pixel with around 25% fill factor is shown; each lens 10' of Fig. 13 is illuminating (for an identical angle of incidence) a different quadrant of the pixel. The interlaced $2 \times 2$ images gives the full image resolution with a virtual fill-factor of 100%.

The micro-optical component 100 of Fig. 13 optical system shows a lens height that is only half of the required focal length that would be required to achieve the full image area with a single lens. The lateral size of the system is still determined by the imager size.

With the micro-optical component 100 of Fig. 13 the use of a set of $2 \times 2$ lenses allows to improve the image resolution by subpixel sampling; the obuscrated area of the lenses 10' allows to homogenize the intensity distribution across the image.

The micro-optical component according to the invention is well adapted to cooperate with pixels having a low fill factor, for example with pixels wherein the active area is allocated in one quadrant only. Each of the 2 x 2 lenses can be positioned to image an identical object point to one of the four quadrants of the pixel; thus no image processing for distant objects is necessary to interlace the images; and in theory, no loss in contrast will occur. In one preferred embodiment, the increased resolution is visible, if the optical resolution is designed for the subpixel size.

The scaling of the focal length and thereby the system height is a function of the number of incorporated lenses. The nominal FoV of an image sensor is resolved by $N_0$ pixels of a sensor with pixel pitch $p_0$ in a distance z and equipped with a single lens of focal lens $f_0$. In case of M x M lenses, the focal length $f_M$, the size of the subpixel $p_M$ and the number of pixel per lens $N_M$ scale with the number of lenses M, according to the following formulas:

$$f_M = f_0/M \qquad\qquad (5)$$

$$p_M = p_0/M \qquad\qquad (6)$$

$$N_M = N_0/M \qquad\qquad (7)$$

An ideal condition for subpixel sampling is a pixel array with a fill factor ff equal to

$$ff = p_M{}^2/p_0{}^2.$$

Although the number of pixels (with a low fill-factor) is decreasing per lens, the final image that is reconstructed out of $M \times M$ images is of full-resolution. The scaling of the system height is only limited by the required optical resolution of the lens, which has to fulfil the subpixel size $p_M$ and is diffraction limited.

Another possibility to increase the resolution of the final image is to use multiple lenses, e.g. arranged in a square or in a rectangle, so as to perform spatial oversampling, as many identical images reduces noise and therefore increase the signal-to-noise ratio . In this case, the lenses' height allows only small focal lengths and hence only a limited number of pixels per image. However, the oversampling (taking several identical images by identical images) is requires high computational time. The favourite method for pixels with a low fill factor is sub-pixel sampling.

The drawback of the sub-sampling is a limited minimum object distance due to the parallax error and an increased effort in image processing for interleaving the sub-images.

Fig. 15A shows a cut-section view of another embodiment of a micro-optical component 100 according to the invention, showing that the off-set or lens pitch LP between adjacent lenses introduces a parallax error, i.e. there is a position difference $\Delta r = r_2 - r_1$ of the object point P1 on an object plane on the image sensor. As illustrated in Fig. 15B, P1 should be on identical virtual image position (i.e. Δr = 0). In one preferred embodiment, this position difference Δr should not be larger than p/4, so that a black pixel adjacent to a white pixel in the interlaced image does not change the gray values by more than 25% as indicated in the following formula:

$$\Delta r = (r2 - r1) = \text{off-set} \cdot f/z \le p/4 \qquad (8)$$

As the off-set is at least (N + 1/M) · p:

$$(N + 1/M) \cdot p \cdot f/z \le p/4 \qquad (9)$$

Therefore the minimum object distance (MOD) z is:

$$MOD \ge 4 \cdot f \cdot (N + 1/M) \cdot \qquad (10)$$

For example, for a number of pixels N of 160 (i.e. for a resolution of 160 × 160) and a focal length f of 1 mm, the minimum object distance (MOD) is 642 mm for M = 2. For a number of pixels N of 320 (i.e. for a resolution of 320 × 320) and a focal length f of 1 mm, the minimum object distance (MOD) is 1284 mm.

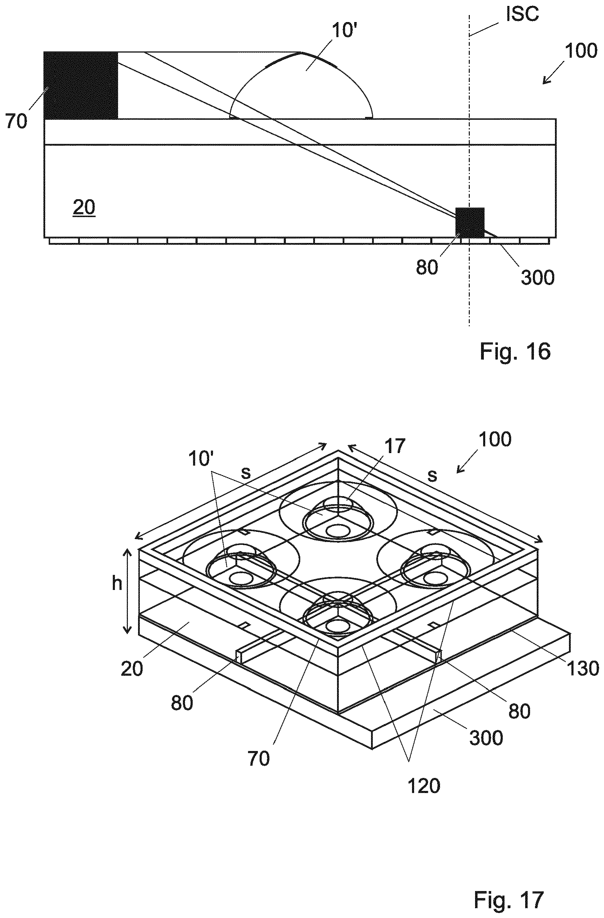

Fig. 16 illustrates a cut-section of an embodiment of a micro-optical component 100, comprising an outer frame 70 around the lens part of the micro-optical component 100, which limits the maximum AOI (e.g. AOI ≤ 60°), moreover, this frame can be used to suppress cross-talk between the quadrant images. In complement and/or in alternative the maximum AOI can be limited by one or more channels 80, e.g. diced channels, in the substrate 20, in particular in correspondence of the normal at the image sensor center ISC, filled with black material.

Fig. 17 shows a perspective view of one embodiment of the micro-optical component 100 according to the invention, connected via a glue layer 130 to an image sensor 300. The height h of the micro-optical component 100 is less than 1.5 mm. e.g. less than 1.4 mm. It has a squared section of side s less than 5mm, e.g. 4.8 mm. It comprises a set of 2 × 2 aspherical lenses 10', with flattened and coated top 17. A black frame 70 surrounds the lenses 10'. Two buffles 80 with black filler are arranged over the image sensor 300 in a cross shape. They cross at the image sensor center. The thickness of the substrate 20 is less than 1mm, e.g. equal to 0.7 mm.

In the embodiment of Fig. 17, the images of each lens 10' are shifted by half a pixel, enabling the image recomposition by simple pixel interleaving.

The micro-optical component 100 of Fig. 7 allows to have 11% of relative illumination at AoV = 120° (without the obscured area, the relative illumination is less than 5%), and more than 50% of relative illumination at AoV < 90° (without the obscured area, the AoV is less than 62°). The minimum object distance MOD is 1250 mm for parallax error < 1.8 μm.

As for the example of Figs. 5 and 6, the apertures sizes and/or the thickness of the glue layer 130 can be varied for compensating substrate manufacturing tolerances.

The imaging device is therefore composed by three elements requiring high-precision assembly, e.g. using adhesive or gluing layers:

- the lens(es) on the substrate
- the aperture (and possibly the baffles/channels) on the substrate
- the micro-optical component on the image sensor.

The present invention concerns also an imaging device comprising

- the micro-optical 100 component as described here above,
- an image sensor 300 comprising an array of light-detecting element, e.g. pixels,

the second surface 21 of the substrate 20 of the micro-optical component 100 being connected, e.g. directly connected via a glue layer 130, to said image sensor 300, so that the image is detected by the image sensor and wherein the area of the obscuration element allows that the optical resolution of the micro-optical component is equal or larger than the image resolution given by the light detective elements.

In one embodiment, the pixels have a fill factor less than 70% and/or the pitch of pixels is larger than 3 μm, e.g. 5 μm.

The present invention concerns also a method for manufacturing the micro-optical component as described above, comprising the following steps:

- providing on the first surface 21 of the micro-optical component, except for the aperture 12, by a first layer 120 preventing the light to pass through it,
- creating at least one lens 10; 10' over this layer 120 so that this lens 10; 10' cover said aperture 12,
- providing in, on, in front or behind the lens 10; 10' an obscuration element,

the area of the obscuration element being less than the area of the lens, so that at least a first part of a light beam incident to the lens pass through the lens, thereby generating the image on an array of light detective elements, said obscuration element preventing at least a second part of said light beam to pass through the lens, so as to improve an intensity homogeneity of the image and/or to reduce image blur due to spherical aberrations.

In one embodiment, the method further comprises:

- dicing of at least one channel 80 on the substrate 20,
- filling said channel(s) with black material,
- connecting, e.g. by glueing, a light shield 70, so as to limit the maximum AOI.

The present invention concerns also a method for manufacturing the imaging device as described above, comprising the following steps:

- manufacturing the micro-optical component 100 with the method described above,
- connecting, e.g. directly connecting by a glue layer 130, the micro-optical component 100 to the image sensor 300.

**Reference signs used in the figures**

| | |
|---|---|
| 10 | Lens with spherical profile |
| 10' | Lens with aspherical profile |
| 12 | Centred aperture |
| 12' | Smaller aperture |
| 12" | Shifted aperture |
| 13 | Mold |
| 14, 15, 16 | Arcs of circle |
| 17 | Flattened top |
| 18 | Tip of the lens with aspherical profile |
| 20 | Substrate |
| 21 | First surface of the substrate |
| 22 | Second surface of the substrate |
| 40 | Obscured area |
| 50 | Unobscured area |
| 70 | Light shield |
| 80 | Channel |
| 100 | Micro-optical component |
| 120 | Substrate obscured area or layer |
| 130,140 | Glue layer |
| 300 | Pixel array |
| 400 | Cover |
| 500 | Shadow mask |
| A | Axis of symmetry of the lens |
| C | Center of the aperture |
| C1, C2 | Centres of the circles |
| R1, R2 | Rays of the circles |
| d, d' | Shift or distance |
| h | Height |
| s | Side |
| px | Pixel |
| P1, P2 | Points |

LP          Lens pitch

**Claims**

1.  A micro-optical component (100) for generating an image on an array of light detective elements, e.g. pixels, said micro-optical (100) component comprising:

    - a substrate (20), said substrate (20) comprising a first surface (21) and a second surface (22), wherein the first surface (21) comprises an aperture (12), and the second surface (22) is arranged to be placed on said array (300),
    - a lens (10; 10'), said lens (10; 10') being placed on said first surface (21) of said substrate (20) so as to cover said aperture (12), the focal point of the lens (10; 10') belonging to said second surface (22) of the substrate (20),

    **characterised in that**,
    said micro-optical component (100) comprises an obscuration element,
    the area of the obscuration element being less than the area of the lens, so that at least a first part of a light beam incident to the lens pass through the lens, thereby generating the image on an array of light detective elements,
    said obscuration element preventing at least a second part of said light beam to pass through the lens, so as to improve the intensity homogeneity of the image and/or to reduce image blur due to spherical aberrations.

2.  The micro-optical component (100) claim 1, wherein said obscuration element defining at the lens an obscured area (40) and an unobscured area (50),
    wherein said second part of the light beam is prevented to pass through the lens by said obscured area (40),
    and wherein said first part of the light beam is allowed to pass through said unobscured area (50),
    the ratio ($\varepsilon$) between the obscured area (50) and the total area at the entrance pupil being comprised in the range from 20% to 50%.

3.  The micro-optical component (100) of one of claims 1 to 2,
    wherein said obscuration element is on the lens, in the lens, in front of the lens or behind the lens.

4.  The micro-optical component (100) of one of claims 1 to 3, said lens (10; 10') comprising an axis of symmetry (A), said obscured area (40) being symmetric with regard to said axis of symmetry (A).

5.  The micro-optical component (100) of one of claims 1 to 4,
    wherein said obscuration element improves the image resolution for a first range of the angles of incidence while lowers the image resolution for a second range of the angles of incidence.

6.  The micro-optical component (100) of one of claims 1 to 5, said lens (10') having an aspherical profile, said aperture (12) comprising a center (C), said lens (10') being placed on said first surface (21) so that the axis of symmetry (A) of the lens (10') passes through said center (C).

7.  The micro-optical component (100) of one of claims 1 to 6, said lens (10') comprising a flattened top (17), said flattened top (17) comprising said obscured area (40).

8.  The micro-optical component (100) of one of claims 1 to 5, said lens (10) having a spherical profile, said aperture (12) comprising a center (C), said lens (10) being placed on said first surface (21) so that the axis of symmetry (A) of the lens (10) does not pass through said center (C) so that there is a shift (d) from said center (C) to said axis of symmetry (A), wherein in particular the first range comprises angles of incidence (AOI) in the range of 11°-27° < AOI < 41°-50°.

9.  The micro-optical component (100) of one of claims 1 or 8, comprising more than one lens (10; 10'), wherein in particular each lens is shifted by a fraction of the pixel size towards each other to allow sub-pixel sampling and/or wherein the number of lenses allows over-sampling of the pixels.

10. The micro-optical component (100) of claim 9 when depending from claim 8, comprising a set of M x M spherical lenses (10), wherein the size of said shift (d) is arranged so that only the best resolution parts of the images generated by lenses (10) are captured by the array of light detective elements.

**11.** The micro-optical component (100) of claim 9 when depending from one of claims 6 to 7, comprising a set of M $\times$ M aspherical lenses (10), the pitch between two consecutive lenses (10; 10') is selected according to the following formula:

$$LP = (N/M + 1/M) \cdot p$$

Wherein N is the number of pixels of the pixel array (300) and p is the pixel pitch.

**12.** The micro-optical component (100) of one of claims 9 to 11, comprising an outer frame (70) so as to limit the maximum AOI and/or supress cross-talk between the images of each lens (10; 10'), and/or the substrate (20) comprising one or more channels (80), filled with black material.

**13.** An imaging device comprising

    - the micro-optical (100) component according to one of claims 1 to 12,
    - an image sensor (300) comprising an array of light-detecting elements, e.g. pixels,

the second surface (21) of the substrate (20) of said micro-optical component (100) being connected, e.g. directly connected via a glue layer (130), to said image sensor (300), so that the image is detected by said image sensor wherein the area of the obscuration element allows that the optical resolution of the micro-optical component is equal or larger than the image resolution given by the light detective elements.

**14.** The imaging device of the previous claim, wherein the pixels have a fill factor less than 70% and/or wherein the size of pixels is larger than 3 $\mu$m, e.g. 5 $\mu$m.

**15.** A method for manufacturing the micro-optical component according to one of claims 1 to 12, comprising the following steps:

    - providing on the first surface (21) of the micro-optical component, except for the aperture (12), by a first layer (120) preventing the light to pass through it,
    - creating at least one lens (10; 10') over said layer (120) so that said lens (10; 10') cover said aperture (12),
    - providing in, on, in front or behind said lens (10; 10') an obscuration element,

the area of the obscuration element being less than the area of the lens, so that at least a first part of a light beam incident to the lens pass through the lens, thereby generating the image on an array of light detective elements, said obscuration element preventing at least a second part of said light beam to pass through the lens, so as to improve an intensity homogeneity of the image and/or to reduce image blur due to spherical aberrations.

**16.** The method of the previous claim, further comprising:

    - dicing of at least one channel (80) on the substrate (20),
    - filling said channel(s) with black material,
    - connecting, e.g. by glueing, a light shield (70) so as to limit the maximum AOI.

**17.** A method for manufacturing the imaging device according to one of claims 13 or 14, comprising the following steps:

    - manufacturing the micro-optical component (100) with the method according to one of claims 15 or 16,
    - connecting, e.g. directly connecting by a glue layer (130), the micro-optical component (100) to the image sensor (300).

Fig. 1A

Fig. 1B

Fig. 1C

Fig.2A

Fig.2B

Fig. 3

Fig. 4

Fig. 5

Fig. 6

Fig. 7

Fig. 8

Fig. 9

Fig. 10

**Fig. 11A**

**Fig. 11B**

**Fig. 11C**

12　120

10'　120

500

20

20

20

20

11

20

**Fig. 12A**

**Fig. 12B**

13

11

20

**Fig. 12C**

11

20

**Fig. 12D**

10

20

**Fig. 12E**

Fig. 13

Fig. 14

Fig. 15A

Fig. 15B

ISC

10'

100

70

20

80

300

Fig. 16

100

10'

17

s

s

h

20

130

80

80

70

300

120

Fig. 17

Europäisches
Patentamt

European
Patent Office

Office européen
des brevets

## EUROPEAN SEARCH REPORT

Application Number

EP 18 18 2654

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2018/095193 A1 (WANG MAO-CHIN [US] ET AL) 5 April 2018 (2018-04-05) | 1-7,9, 10,12-17 | INV. G02B13/00 |
| A | * paragraphs [0026], [0028], [0029] * <br> * figure 2A * | 8,11 | H01L27/146 B29D11/00 |
| Y | WO 01/24173 A1 (RICHARD JENKIN A [US]) 5 April 2001 (2001-04-05) | 1-7,9, 10,12-17 | |
| A | * page 18, line 15 - line 23 * <br> * page 17, line 20 - line 21 * <br> * figure 13 * | 8,11 | |
| Y | US 2006/050409 A1 (GEORGE NICHOLAS [US] ET AL) 9 March 2006 (2006-03-09) | 1-7,9, 10,12-17 | |
| A | * abstract * <br> * figure 2 * | 8,11 | |

TECHNICAL FIELDS
SEARCHED     (IPC)

G02B
H01L
B29D

The present search report has been drawn up for all claims

| Place of search | Date of completion of the search | Examiner |
|---|---|---|
| Munich | 11 January 2019 | Denise, Christophe |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 18 18 2654

This annex lists the patent family members relating to the patent documents cited in the above-mentioned European search report.
The members are as contained in the European Patent Office EDP file on
The European Patent Office is in no way liable for these particulars which are merely given for the purpose of information.

11-01-2019

| Patent document cited in search report | | Publication date | Patent family member(s) | | Publication date |
|---|---|---|---|---|---|
| US 2018095193 | A1 | 05-04-2018 | CN | 107884850 A | 06-04-2018 |
| | | | TW | 201814403 A | 16-04-2018 |
| | | | US | 2018095193 A1 | 05-04-2018 |
| WO 0124173 | A1 | 05-04-2001 | AU | 7704700 A | 30-04-2001 |
| | | | WO | 0124173 A1 | 05-04-2001 |
| US 2006050409 | A1 | 09-03-2006 | AU | 2005283143 A1 | 16-03-2006 |
| | | | CA | 2577735 A1 | 16-03-2006 |
| | | | CN | 101048691 A | 03-10-2007 |
| | | | EP | 1789830 A2 | 30-05-2007 |
| | | | IL | 181671 A | 30-11-2010 |
| | | | JP | 2008511859 A | 17-04-2008 |
| | | | KR | 20070057231 A | 04-06-2007 |
| | | | SG | 142313 A1 | 28-05-2008 |
| | | | US | 2006050409 A1 | 09-03-2006 |
| | | | US | 2008075386 A1 | 27-03-2008 |
| | | | US | 2008089598 A1 | 17-04-2008 |
| | | | US | 2008151388 A1 | 26-06-2008 |
| | | | WO | 2006028527 A2 | 16-03-2006 |

EPO FORM P0459

For more details about this annex : see Official Journal of the European Patent Office, No. 12/82